# EUROPEAN PATENT APPLICATION

(11) **EP 1 638 144 A2**
(43) Date of publication of application: **22.03.2006**
(21) Application number: 05019678.1
(22) Date of filing: 09.09.2005
(51) Int. Cl.: H01L 23/528

(54) **Method for designing semiconductor device and semiconductor device**

(30) Priority: 15.09.2004 JP 2004268769
(71) Applicant: Matsushita Electric Industries Co., Ltd., Kadoma-shi, Osaka 571-8501 (JP)
(72) Inventor: Araki, Takayuki, Nara-shi Nara 631-0024 (JP); Kimura, Fumihiro, Nara-shi Nara 631-0835 (JP); Shimada, Junichi, Osaka-shi Osaka 532-0022 (JP); Fujita, Kazuhisa, Nagaokakyo-shi Kyoto 617-0833 (JP)
(74) Representative: Grünecker, Kinkeldey, Stockmair & Schwanhäusser Anwaltssozietät

(57) **Abstract**

A method for designing a semiconductor device and a semiconductor device of the present invention permits the achievement of a predetermined pattern area ratio while power supply lines are reinforced by connecting a dummy metal line, which is formed in an unoccupied region of a wiring layer for the purpose of achieving the predetermined area ratio, at its two or more points with a power supply line for VDD or VSS.

## Description

### BACKGROUND OF THE INVENTION

### (1) Field of the Invention

The present invention relates to a semiconductor device formed with a dummy metal line and a method for designing the same.

### (2) Description of Related Art

The advancement of the miniaturization and increased integration of large scale integration (LSI) semiconductor devices has increased the necessity for finer and more complicated pattern formation. In such circumstances, restrictions to the process conditions that achieve pattern formation as designed have been increasing. For example, in a wiring pattern formation process, after a conductive film, such as a polysilicon layer, an aluminum layer, a metal silicide layer, or the like, is formed, a desired mask pattern is formed by photolithography, and thereafter, etching is performed using the mask pattern, whereby the wiring pattern is formed.

In an etching step for an interconnect pattern, part of the conductive film which is exposed through the mask pattern is selectively etched. Even if the conditions of the etching step are optimized, the etching rate varies according to a variation in the density of a mask pattern area to the entire substrate region (pattern area ratio). As a result, the etching accuracy deteriorates when the mask pattern area is excessively large or excessively small.

Such problems may also occur in the formation of a diffusion layer. In the case where the ion implantation region is too small for the formation of the diffusion layer, localization of ions occurs in the region so that a desired diffusion profile is not obtained.

On the other hand, CMP (Chemical Mechanical Polishing) method has been proposed for planarization of the substrate surface. In this method, mechanical polishing and chemical polishing are concomitantly performed on an insulating film which has been formed over a substrate surface by a coating method, a CVD (Chemical Vapor Deposition) method, or the like, whereby a flat substrate surface (the surface of the insulating film) is achieved. However, in the case where the pattern density of an underlying wiring layer formed of aluminum wirings, for example, is small, i.e., in the case where a region larger than a predetermined area includes no wiring pattern, the insulating film cannot have a flat surface even if the insulating film on the wiring layer is formed thicker. As a result, a concavity is formed in the region including no wiring pattern even when CMP is performed on the insulating film, and even in the following steps, the concavity is still left.

To satisfy the density of a wiring pattern obtained based on the process conditions, there is suggested a method in which a dummy pattern is located in an unoccupied region of an LSI. For example, Japanese Unexamined Patent Publication No. 5-343546 and other publications suggest a method in which a dummy pattern is positioned in a large unoccupied region of an LSI enough to prevent a capacitance produced by the formation of a dummy pattern from affecting the LSI and a method in which a dummy pattern is positioned to decrease the wiring capacitance.

### SUMMARY OF THE INVENTION

However, an unoccupied region in which a capacitance does not affect existing circuits hardly exists in a current highly-integrated LSI. Furthermore, even if dummy patterns are formed only in the unoccupied region in which a capacitance does not affect the circuits, the area ratio of a wiring pattern obtained based on the process conditions cannot be achieved.

In view of the above, dummy patterns are to be fonned also in existing circuits while a capacitance is taken into account. Under present circumstances, in many cases, dotted dummy patterns of floating nodes are formed to decrease the wiring capacitance as much as possible. Such dummy patterns are used only for the purpose of achieving the area ratio of a wiring pattern obtained based on the process conditions.

In the current LSI design using a fine process, reduction in the power supply voltage causes a slight voltage drop (IR-Drop). This prevents a desired operation of a circuit. To cope with this problem, it is effective that power supply lines are reinforced in an unoccupied region of a circuit to ensure the operating margin of the circuit. Furthermore, it is also considered as an effective measure for coping with the above problem that a decoupling capacitance is formed between power supply lines to absorb noise.

However, since, in the known adjustment of the area ratio, dummy patterns formed in an unoccupied region have been dotted dummy patterns of floating nodes and the unoccupied region has been used to achieve the obtained pattern area ratio, it has been extremely difficult to reinforce power supply lines after the placement of the dummy patterns. Furthermore, in general, a wiring pattern for the reinforcement of power supply lines is formed without concern for the pattern area ratio. When power supply lines are reinforced to an excessive degree and then the area ratio is to be adjusted, it is often difficult to achieve the obtained pattern area ratio. In some cases, the design of an LSI must be significantly modified.

It is an object of the present invention to provide a semiconductor device that prevents a voltage drop while ensuring a predetermined or larger pattern area ratio and a method for designing the same.

A semiconductor device according to a first aspect of the present invention includes: a power voltage supply unit; a plurality of power supply lines connected to the power voltage supply unit or ground, formed in a plurality of wiring layers and arranged in a grid-like form; and a first dummy metal line formed in at least one of the plurality of wiring layers and connected at its two or more points to the power voltage supply unit or ground.

Therefore, while a predetermined pattern area ratio is achieved by forming the dummy metal line, the grid-like power supply lines can be reinforced. For example, if the first dummy metal line is connected to the power voltage supply unit, the semiconductor device is effective in such cases that only some of the power supply lines connected to VDD have a sharply dropped voltage.

The semiconductor device may further include a second dummy metal line formed in at least one of the plurality of wiring layers and connected at its two or more points to one of the power sources having the opposite polarity to the power source to which the first dummy metal line is connected. In this way, a wiring capacitance can be formed between one of the wiring layers in which the first dummy metal line is formed and another of the wiring layers in which the second dummy metal line is formed.

The first and second dummy metal lines may be formed in different wiring layers. This can prevent the production yield from being reduced due to a short.

The semiconductor device may further include an electrically isolated floating-node dummy metal line formed in one of the wiring layers other than another of the wiring layers in which the first dummy metal line and the power supply lines are formed. In this way, a predetermined pattern area ratio can be achieved by forming the floating-node dummy metal line in the wiring layer that is crowded with signal lines or other lines, and the grid-like power supply lines can be reinforced.

The semiconductor device may further include a third dummy metal line formed in at least one of the plurality of wiring layers and connected at its two or more points to one of the power sources having the opposite polarity to the power source to which the first dummy metal line is connected, wherein one of the wiring layers in which the first dummy metal line is formed and another of the wiring layers in which the third dummy metal line is formed may be alternately stacked. Therefore, a drop in voltage of the grid-like power supply lines can be sufficiently coped with, and a wiring capacitance can be formed between dummy metal lines formed in any vertically adjacent two of wiring layers, respectively.

A semiconductor device according to a second aspect of the present invention includes: a plurality of wiring layers; a power voltage supply unit; and a plurality of power supply lines connected to the power voltage supply unit or ground and arranged in a grid-like form, wherein, when some of the plurality of power supply lines connected to the power voltage supply unit are first power supply lines and the other ones of the plurality of power supply lines connected to the ground are second power supply lines, a plurality of pairs of the first and second power supply lines are formed in one of the wiring layers, two of the first power supply lines are adjacent to each other, and two of the second power supply lines are adjacent to each other, a first dummy metal line is formed between adjacent two of the first power supply lines so as to be connected to the power voltage supply unit, and a second dummy metal line is formed between adjacent two of the second power supply lines so as to be connected to the ground.

In this way, a drop in voltage of the grid-like power supply lines can be coped with. Furthermore, even if a dummy metal line comes into contact with any adjacent two of power supply lines between which the dummy metal line is interposed, a short between different power sources is not caused. This can avoid reduction in the production yield.

A semiconductor device according to a third aspect of the present invention includes: a plurality of wiring layers; a power voltage supply unit; an active element formed in a middle region of the semiconductor device; an I/O cell for receiving a signal from the outside and transmitting a signal from the active element to the outside; a plurality of power supply lines connected to the power voltage supply unit or ground, arranged in a grid-like form and formed in an outer region of the semiconductor device located around the middle region; a dummy metal line formed in the outer region and connected at its two or more points to the power voltage supply unit or ground; and an electrically isolated floating-node dummy metal line formed in a region other than the outer region.

Therefore, a voltage drop caused in the middle region can be suppressed by sufficiently reinforcing the grid-like power supply lines located in part of the I/O cell from which power is derived. Furthermore, since a floating-node dummy metal line having great design flexibility is formed, this can achieve a predetermined pattern area ratio with ease.

Another dummy metal line formed in the outer region and connected at its two or more points to the power voltage supply unit or ground may be formed in at least one of the wiring layers other than the other ones of the wiring layers in which the power supply lines are formed. In this way, even when the outer region of a semiconductor chip on which a semiconductor device is formed is left as dead space, a voltage drop in the middle region can be coped with more effectively.

A semiconductor device according to a fourth aspect of the present invention includes: a plurality of wiring layers; a power voltage supply unit; one or more dummy metal poles each passing through the plurality of wiring layers and connected to the power voltage supply unit or ground; and a plurality of dummy metal lines each formed in one of the wiring layers without shifting into another of the wiring layers and connected to any one of the dummy metal poles.

Therefore, when a circuit is modified by processing the wiring layers, it can be easily modified by cutting the dummy metal line.

The dummy metal poles may comprise at least one first dummy metal pole connected to the power voltage supply unit and at least one second dummy metal pole connected to the ground, and some of the wiring layers in which some of the dummy metal lines connected to the first dummy metal pole are formed and the other ones of the wiring layers in which the other ones of the dummy metal lines connected to the second dummy metal pole are formed may be alternately stacked. In this way, a wiring capacitance can be formed between the dummy metal lines connected to the first dummy metal pole and the dummy metal lines connected to the second dummy metal pole.

A semiconductor device according to a fifth aspect of the present invention includes: a plurality of wiring layers; a signal line; and an electrically isolated floating-node dummy metal line formed above or below one of the wiring layers in which the signal line is formed, wherein the floating-node dummy metal line and the signal line are formed without overlapping with each other when viewed in a plane.

Therefore, even when an interlayer insulating film becomes thinner with miniaturization of devices, a wiring capacitance can be prevented from being produced between the signal line and the floating-node dummy metal line. This can suppress a signal delay.

Part of the floating-node dummy metal line crossing the signal line-wheri viewed in a plane may be removed. In this way, part of the floating-node dummy metal line overlapping with the signal line can be removed.

A semiconductor device according to a sixth aspect of the present invention includes a signal line and a dummy metal line formed in a wiring layer in which the signal line is formed, wherein an isolated contact hole is formed to reach the signal line and a contact hole is formed in one of the wiring layers in which the isolated contact hole is formed to reach the dummy metal line. This can suppress defective formation of contact holes and prevent the production yield from being reduced.

A method for designing a semiconductor device of the present invention using a computer including an input section, a voltage drop analysis section, a power supply path search section, dummy metal line layout data generation section, and an output section, includes the steps of: (a) entering before-dummy-metal-line-formation layout data of the semiconductor device into the input section; (b) using the voltage drop analysis section to analyze the before-dummy-metal-line-formation layout data and identify part of the semiconductor device to which power is insufficiently supplied; (c) using the power supply path search section to search for a power supply path for reinforcing, in the part of the semiconductor device to which power is insufficiently supplied, power supply lines by using a dummy metal line and the polarity of the dummy metal line; and (d) using the dummy metal line layout data generation section to generate layout data of the dummy metal line based on the path and polarity determined in the step (c).

With this method, a dummy metal line connected to the power voltage supply unit or ground can be formed in part of the semiconductor device to which power is insufficiently supplied. Therefore, a voltage drop can be coped with more effectively.

### BRIEF DESCRIPTION OF THE DRAWINGS

FIG. **1** is a diagram showing a semiconductor device according to a first embodiment of the present invention.
FIG. **2** is a diagram showing a semiconductor device according to a second embodiment of the present invention.
FIG. **3** is a diagram showing a semiconductor device according to a third embodiment of the present invention.
FIG. **4** is a flow chart showing a method for designing a semiconductor device according to a fourth embodiment of the present invention.
FIG. **5** is a block diagram showing the configuration of a computer for executing the method for designing a semiconductor device according to the fourth embodiment of the present invention.
FIG. **6** is a diagram showing a semiconductor device according to a sixth embodiment of the present invention.
FIG. **7** is a diagram showing a semiconductor device according to an eighth embodiment of the present invention.
FIG. **8** is a diagram showing a semiconductor device according to a ninth embodiment of the present invention.
FIG. **9** is a perspective view showing a semiconductor device according to a tenth embodiment of the present invention.
FIG. **10** is a diagram showing a semiconductor device according to an eleventh embodiment of the present invention.

### DETAILED DESCRIPTION OF THE INVENTION

Embodiments of the present invention will be described hereinafter in detail with reference to the drawings.

### (Embodiment 1)

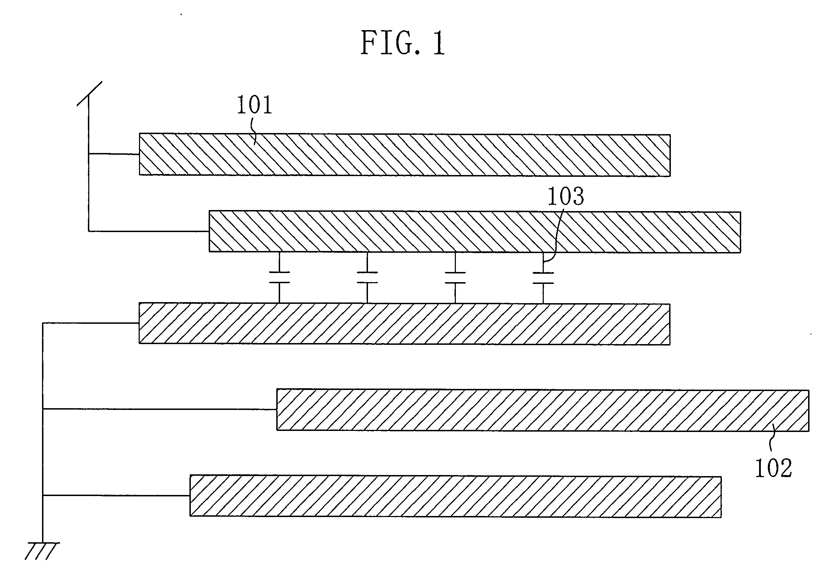

FIG. **1** is a diagram showing a semiconductor device according to a first embodiment of the present invention. As shown in FIG. **1,** the semiconductor device of this embodiment represents an LSI and includes a dummy metal line **101** connected to a power voltage supply unit (VDD) and formed in a first wiring layer (hereinafter, referred to as "upper-wiring-layer dummy metal line **101")** and a dummy metal line **102** connected to the ground (VSS) and formed in a second wiring layer (hereinafter, referred to as "lower-wiring-layer dummy metal line **102").** In this case, the first wiring layer is formed on or above the second wiring layer, and a wiring capacitance **103** is formed between respective regions of the upper-wiring-layer dummy metal line **101** and the lower-wiring-layer dummy metal line **102** overlapping with each other when viewed in a plane. When the first wiring layer is located immediately on the second wiring layer, the wiring capacitance **103** becomes largest. Otherwise, one or more wiring layers may be formed between the first wiring layer and the second wiring layer. In the semiconductor device of the present invention, power supply lines are formed in two or more wiring layers and arranged in a grid-like form.

The upper-wiring-layer dummy metal line **101** is connected at its two or more points to the power voltage supply unit, and the lower-wiring layer dummy metal line **102** is connected at its two or more points to the ground. If both the dummy metal lines **101** and **102** were connected only at their respective one points to the power voltage supply unit and the ground, respectively, this would interfere with the establishment of power supply paths so that the power supply would be hardly stabilized. Since each of the dummy metal lines **101** and **102** is connected at its two or more points to the power voltage supply unit or the ground, a power supply path can be established in part of the LSI in which the power supply would not be stabilized if both the dummy metal lines 101 and 102 were connected only at their respective one points to the power voltage supply unit and the ground, respectively. This leads to the stabilized power supply.

These dummy metal lines are made of a conductive material, such as aluminum, copper or polysilicon.

With the above-mentioned structure, the formation of dummy metal lines can achieve a predetermined or larger pattern area ratio and permits the reinforcement of grid-like power supply lines of the LSI. A wiring capacitance can be formed at the interface between a first wiring layer and a second wiring layer. In this way, the power supply can be stabilized without placing capacitive cells or other elements between a power supply voltage line and a ground line. Furthermore, since the polarity of a dummy metal line is identified based on the wiring layer in which the dummy metal line is formed, this can avoid a short in the same wiring layer and prevent the production yield from being reduced.

In an example shown in FIG. **1,** a dummy metal line in the upper wiring layer is connected to the power voltage supply unit, and a dummy metal line in the lower wiring layer is connected to the ground. When a dummy metal line in the upper wiring layer is connected to the ground and a dummy metal line in the lower wiring layer is connected to the power voltage supply unit, the same effects can be obtained likewise.

In this embodiment, a description was given of the case where the semiconductor device includes an upper-wiring-layer dummy metal line **101** connected to a power voltage supply unit and a lower-wiring-layer dummy metal line **102** connected to the ground. However, for example, when only power supply lines connected to the power voltage supply unit have a sharply dropped voltage, the formation of only dummy metal lines connected to the power voltage supply unit is also effective for the stabilization of the power supply.

The upper-wiring layer dummy metal line 101 and the lower-wiring layer dummy metal line **102** may be formed in the same wiring layer.

### (Embodiment 2)

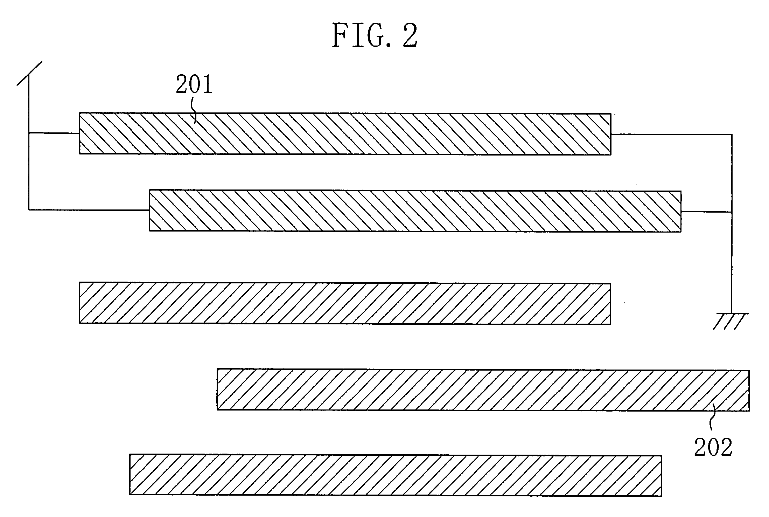

FIG. **2** is a diagram showing a semiconductor device according to a second embodiment of the present invention. As shown in FIG. **2,** the semiconductor device of this embodiment represents an LSI and includes a dummy metal line **201** connected at its two or more points to a power voltage supply unit (VDD) or the ground (VSS) and formed in a first wiring layer (hereinafter-, referred to as "upper-wiring-layer dummy metal line **201")** and a dummy metal line **202** isolated from the power voltage supply unit and the ground and formed in a second wiring layer (hereinafter, referred to as "lower-wiring-layer floating-node dummy metal line **202").** When the upper-wiring-layer dummy metal line **201** is formed, it is connected to one of the power voltage supply unit and the ground to which it is more easily connected. Furthermore, the floating-node dummy metal line **202** is formed in a wiring layer in which no power supply line is formed. The other structure is similar to the semiconductor device of the first embodiment.

With this structure, grid-like power supply lines are reinforced by forming the upper-wiring layer dummy metal line **201.**

On the other hand, even when a dummy metal line connected to the power voltage supply unit or the ground is to be formed in the lower wiring layer to reinforce grid-like power supply lines, space necessary for connecting the dummy metal line to the power voltage supply unit or the ground cannot be ensured due to a large number of signal lines. This may lead to the adverse effect that a predetermined pattern area ratio cannot be achieved. To cope with this, a dummy metal line having no polarity, i.e., a floating-node dummy metal line is formed in the semiconductor device of this embodiment. This can achieve a desired pattern area ratio. As a result, a voltage drop can be coped with and the desired area ratio can be achieved, both with more efficiency than in the first embodiment.

### (Embodiment 3)

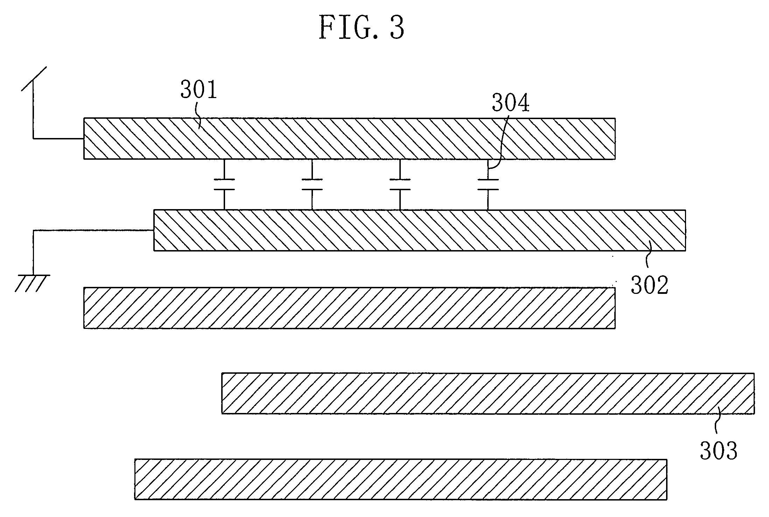

FIG. **3** is a diagram showing a semiconductor device according to a third embodiment of the present invention. As shown in FIG. **3,** the semiconductor device of this embodiment represents an LSI and includes a dummy metal line **301** connected to a power voltage supply unit (VDD) and located in a first wiring layer (hereinafter, referred to as "first upper-wiring-layer dummy metal line **301"),** a dummy metal line **302** connected to the ground (VSS) and formed in a different wiring layer (for example, a second wiring layer) from that of the first upper-wiring-layer dummy metal line **301** (hereinafter, referred to as "second upper-wiring-layer dummy metal line **302"),** and a dummy metal line **303** isolated from the power voltage supply unit and the ground and formed in a second wiring layer (hereinafter, referred to as "lower-wiring-layer floating-node dummy metal line **303").** In this example, the first wiring layer is formed on the second wiring layer. A wiring capacitance **304** is produced between respective adjacent parts of the first upper-wiring-layer dummy metal line **301** and the second upper-wiring layer dummy metal line **302.**

In the formation of dummy metal lines, the first upper-wiring-layer dummy metal line **301** is formed so as to be connected at its two or more points to the power voltage supply unit, and the second upper-wiring-layer dummy metal line **302** is formed so as to be connected at its two or more points to the ground. In this way, a wiring capacitance **304** is produced between the dummy metal lines **301** and **302.**

Meanwhile, the lower-wiring-layer floating-node dummy metal line **303** is formed in a wiring layer located below the first wiring layer.

In the semiconductor device of the second embodiment, a dummy metal line located in the first wiring layer formed as the upper layer is connected to one of a power voltage supply unit and the ground to which it is more easily connected. However, in the semiconductor device of this embodiment, the first upper-wiring-layer dummy metal line **301** and the second upper-wiring-layer dummy metal line **302** are formed so as to be connected to power supplies of different polarities. In this way, a drop in voltage of grid-like power supply lines can be sufficiently coped with and a large wiring capacitance can also be formed between respective adjacent parts of the upper wiring layers.

Furthermore, like the second embodiment, an electrically floating dummy metal line is formed in the second wiring layer formed as the lower layer. In this way, a sufficiently large pattern area ratio can be achieved.

The above structure can provide a semiconductor device that allows a voltage drop to be more certainly coped with than the semiconductor device of the second embodiment, and facilitates the achievement of a desired pattern area ratio.

### (Embodiment 4)

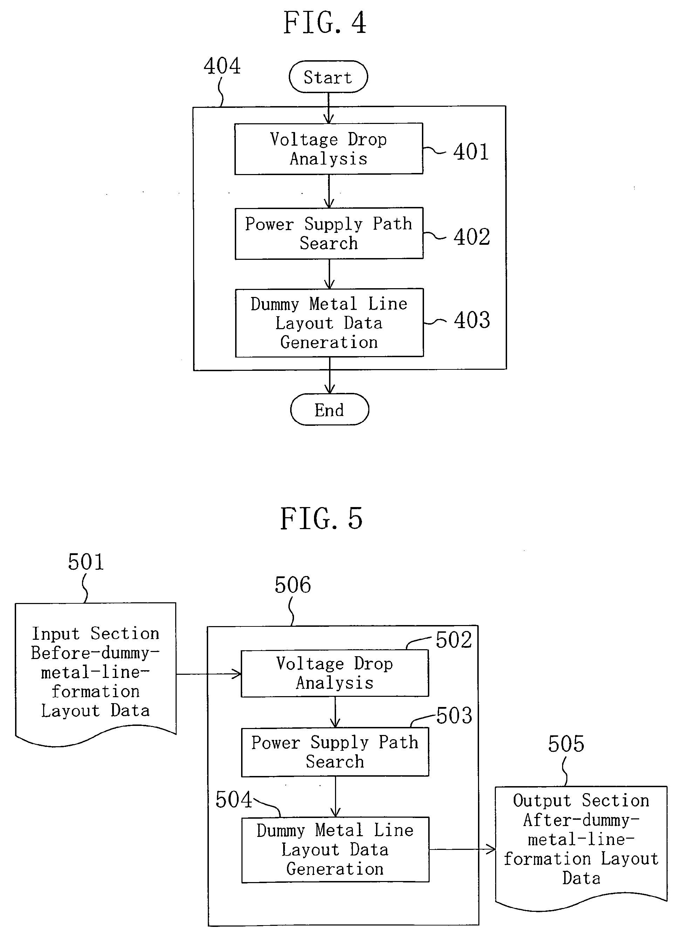

FIG. **4** is a flow chart showing a method for designing a semiconductor device according to a fourth embodiment of the present invention. FIG. **5** is a block diagram showing the configuration of a computer for executing the method for designing a semiconductor device according to this embodiment.

As shown in FIG. **4,** in the semiconductor device designing method of this embodiment, a voltage drop analysis step **401,** a power supply path search step **402,** and a dummy metal line layout data generation step **403** are executed in this order using a computer **404.** Furthermore, as shown in FIG. **5,** the computer **404** includes an input section for receiving layout data **501** of a semiconductor device before the formation of dummy metal lines (hereinafter, referred to as "before-dummy-metal-line-formation layout data **501"),** a voltage drop analysis section **502,** a power supply path search section **503,** a dummy metal line layout data generation section **504,** and an output section through which layout data **505** of a semiconductor device after the formation of dummy metal lines (hereinafter, referred to as "after-dummy-metal-line-formation layout data **505")** are delivered to the outside.

The method for designing a semiconductor device of this embodiment will be described below in more detail.

First, before-dummy-metal-line-formation layout data 501 are received by an input section.

Next, a voltage drop analysis section **502** analyzes the before-dummy-metal-line-formation layout data **501** and identifies part of the semiconductor device to which power is insufficiently supplied (a voltage drop analysis step **401).**

Next, a power supply path search section **503** searches for a power supply path for optimally reinforcing, in the part of the semiconductor device to which power is insufficiently supplied, power supply lines by using dummy metal lines and the polarity of the dummy metal lines (a power supply path search step **402).**

Finally, a dummy metal line layout data generation section **504** generates layout data of dummy metal lines located in the upper wiring layer (first wiring layer) and connected to a power voltage supply unit or the ground on the basis of the path and polarity determined by the power supply path search section **503.** The so obtained after-dummy-metal-line-formation layout data **505** are delivered through the output section to the outside (a dummy metal line layout data generation step **403).**

For the lower wiring layer (second wiring layer), layout data of floating-node dummy metal lines are generated as appropriate after the completion of the above process steps.

In the semiconductor device of the third embodiment, a voltage drop is coped with by forming a dummy metal line in the upper wiring layer. However, the voltage drop is not necessarily coped with in the optimum manner, because the part of the semiconductor device to which power is insufficiently supplied is not taken into account. To cope with this, analysis of a voltage drop and search for a power supply path are implemented, before the formation of dummy metal lines, on the semiconductor device fabricated by the method of this embodiment. In this way, dummy metal lines can be formed after the optimum part of the semiconductor device in which dummy metal lines should be formed to cope with a voltage drop is determined.

As described above, according to the semiconductor device of this embodiment, a voltage drop is coped with more effectively, and a desired pattern area ratio can be easily ensured like the semiconductor device of the third embodiment.

### (Embodiment 5)

In a semiconductor device of this embodiment, grid-like power supply line arrangement formed by vertically adjacent two of wiring layers is formed of pairs of VSS and VDD and pairs of VDD and VSS. These pairs of power supply lines are laid in the same wiring layer to be adjacent to one another in order of, for example, VSS/VDD, VSS/VDD, VDD/VSS, and VSS/VDD. In this embodiment, "VDD" represents power supply lines connected to a power voltage supply unit, and "VSS" represents ground lines connected to the ground.

In this embodiment, wiring layers are configured as follows: The direction toward which power supply lines formed in the upper wiring layer are oriented is orthogonal to the direction to which power supply lines formed in the lower wiring layer are oriented, and the power supply lines formed in the upper wiring layer cross the power supply lines formed in the lower wiring layer. In this case, a dummy metal line is formed in the upper wiring layer so as to be connected to the power voltage supply unit between VDDs, and a dummy metal line is formed in the lower wiring layer so as to be connected to the ground between VSSs.

In this way, for example, when a dummy metal line is formed in part of the semiconductor device interposed between adjacent two of grid-like power supply lines to have the same polarity as that of grid-like power supply lines, this prevents different power supply lines from becoming shorted to one another even with contact between dummy metal lines and grid-like power supply lines. As a result, the production yield can be prevented from being reduced.

### (Embodiment 6)

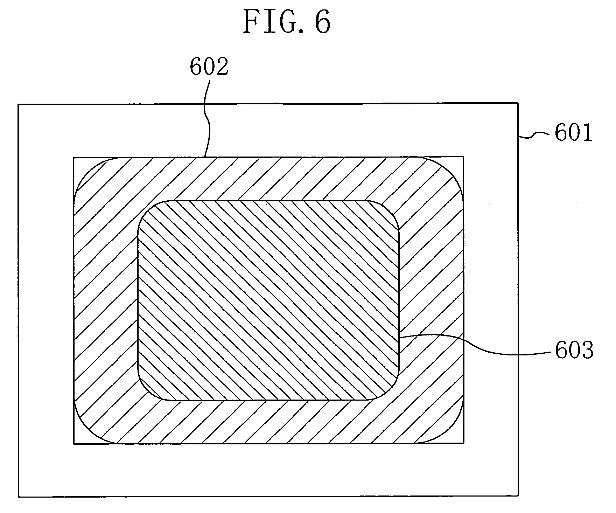

FIG. **6** is a diagram showing a semiconductor device according to a sixth embodiment of the present invention. As shown in FIG. 6, the semiconductor device of this embodiment represents an LSI formed on a semiconductor chip **601** and is formed with a middle region **603** in which active elements or other elements are formed and an outer region **602** located around the middle region **603** and corresponding to part of an input/output (I/O) cell of a semiconductor chip **601** from which power is derived. In the semiconductor device of the present invention, power supply lines are formed in each of two or more wiring layers and arranged in a grid-like form. While a dummy metal line is formed in the outer region **602** of a first wiring layer so as to be connected to a power voltage supply unit, a dummy metal line is formed in the outer region **602** of a second wiring layer located below the first wiring layer so as to be connected to the ground. A floating-node dummy metal line is formed in the middle region **603** to have an electrically floating structure.

According to the semiconductor device of this embodiment, part of grid-like power supply lines located in the part of the I/O cell from which power is derived is reinforced enough by a dummy metal line to which power voltage or ground voltage is supplied. This can suppress a voltage drop to be caused in the middle region **603** of the semiconductor chip **601.** Furthermore, a floating-node dummy metal line having great design flexibility is formed in the middle region **603** of the semiconductor chip **601,** thereby achieving a predetermined pattern area ratio with ease. Although in the above-mentioned example only a floating-node dummy metal line is formed in the middle region **603,** a dummy metal line may be formed in the middle region **603** as necessary so as to be connected to the power voltage supply unit or the ground.

A description was given of the case where a dummy metal line is formed in a single wiring layer so as to be connected to any one of a power voltage supply unit and the ground. However, a dummy metal line connected to a power voltage supply unit and a dummy metal line connected to the ground may be formed in the outer region of a single wiring layer.

### (Embodiment 7)

In a semiconductor device of a seventh embodiment of the present invention, dummy metal lines are formed, using all wiring layers, in the outer region **602** corresponding to part of a semiconductor chip **601** from which power is derived (see FIG. **6)** so as to be connected to a power voltage supply unit or the ground. "Dummy metal lines are formed, using all wiring layers" as described herein means that at least one dummy metal line is formed in each of a plurality of wiring layers. Typically, grid-like power supply lines are formed in an upper wiring layer. However, in the semiconductor device of this embodiment, a dummy metal line can be connected also to the power supply lines located in the lowest wiring layer, which are used for standard cells. A dummy metal line is formed also in a wiring layer in which no power supply line is formed. Furthermore, a floating-node dummy metal line is formed in the middle region **603** of the semiconductor chip **601.**

According to a method for placing a hard macro, such as SRAM, in a semiconductor chip, the outer region of the semiconductor chip may be left as dead space, leading to a wasted region. With the configuration of the semiconductor device of this embodiment, even when the outer region of the semiconductor chip is left as dead space, a voltage drop can be coped with more effectively than in the semiconductor device of the sixth embodiment by forming, using all wiring layers, dummy metal lines so as to be connected to the power voltage supply unit or the ground.

### (Embodiment 8)

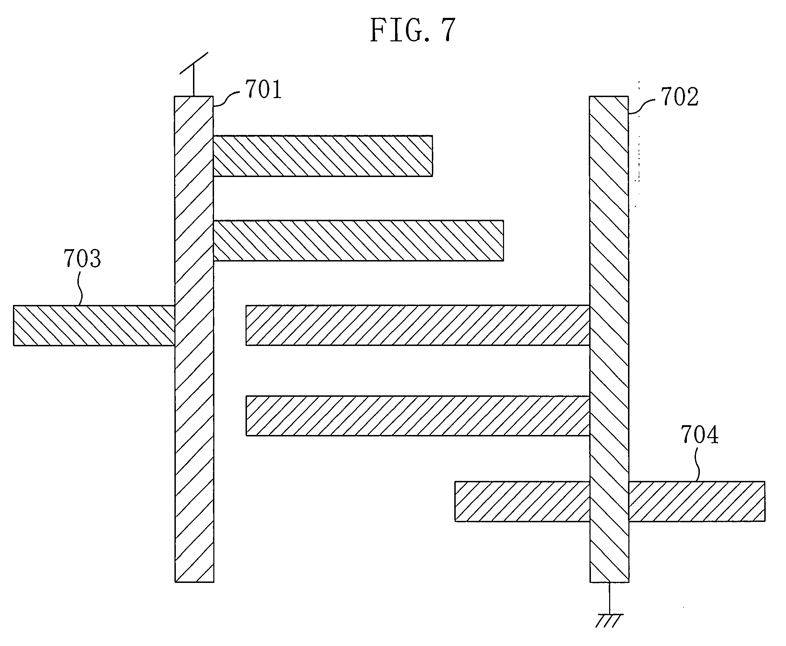

FIG. **7** is a diagram showing a semiconductor device according to an eighth embodiment of the present invention. As shown in FIG. **7,** the semiconductor device of this embodiment includes a VDD dummy metal pole **701** formed in part of a plurality of wiring layers having a low signal line density, connected to a power voltage supply unit (VDD) and passing through the plurality of wiring layers, a VDD dummy metal line **703** formed in one of the wiring layers without shifting into another of the wiring layers and connected to the VDD dummy metal pole **701,** a VSS dummy metal pole **702** formed in part of the plurality of wiring layer having a low signal line density, connected to the ground (VSS) and passing through the plurality of wiring layers, and a VSS dummy metal line **704** formed in one of the wiring layers without shifting into another of the wiring layers and connected to the VSS dummy metal pole **702.**

When a semiconductor device of this embodiment is fabricated, a VDD dummy metal line **703** and a VSS dummy metal line **704** are formed after the formation of a VDD dummy metal pole **701** and a VSS dummy metal pole **702.**

With the above structure, when an LSI formed on the semiconductor chip is modified, the LSI can be easily modified by cutting a dummy metal line, and, even with the cutting of the dummy metal line, a dummy metal line located in another wiring layer need not be modified.

Furthermore, when as many dummy metal poles as possible are formed also in part of wiring layers having a low signal line density to the extent that they do not obstruct signal lines. In this way, dummy metal poles are available also when later modification of a circuit permits the formation of dummy metal lines connected to the dummy metal poles. Even if the formation of dummy metal lines is impossible, dummy metal poles themselves lead to the achievement of a predetermined pattern area ratio. Furthermore, noise in an LSI circuit can be reduced by forming dummy metal poles in the outer region of a semiconductor chip.

### (Embodiment 9)

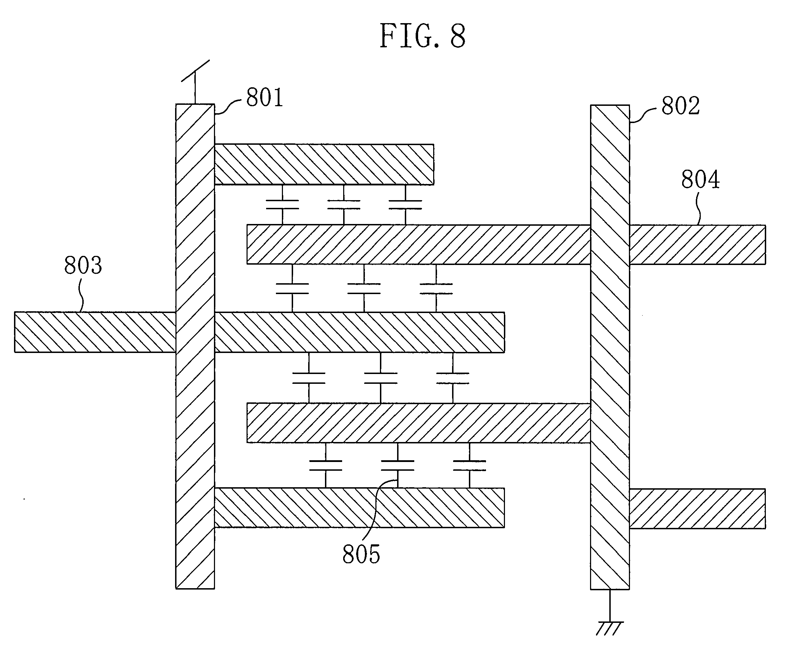

FIG. **8** is a diagram showing a semiconductor device according to a ninth embodiment of the present invention. As shown in FIG. **8,** the semiconductor device of this embodiment includes a plurality of wiring layers and further includes a VDD dummy metal pole **801** connected to a power voltage supply unit (VDD) and passing through the plurality of wiring layers, at least one VDD dummy metal line **803** formed in one of the wiring layers without shifting into another of the wiring layers and connected to the VDD dummy metal pole **801,** a VSS dummy metal pole **802** connected to the ground (VSS) and passing through the plurality of wiring layers, and at least one VSS dummy metal line **804** formed in one of the wiring layers without shifting into another of the wiring layers and connected to the VSS dummy metal pole **802.** The wiring layer in which the VDD dummy metal line **803** is formed and the wiring layer in which the VSS dummy metal line **804** is formed are alternately stacked. For example, the VDD dummy metal line **803** is formed in an even-numbered wiring layer, and the VSS dummy metal line **804** is formed in an odd-numbered wiring layer. A wiring capacitance **805** is formed between the VDD dummy metal line **803** and the VSS dummy metal line **804** in vertically adjacent two of the wiring layers. The VDD dummy metal pole **801** and the VSS dummy metal pole **802** are preferably formed in part of the wiring layers having a low signal line density.

When the semiconductor device of this embodiment is fabricated, a VDD dummy metal pole **801** and a VSS dummy metal pole **802** are formed in part of wiring layers having a low signal line density, and then a VDD dummy metal line **803** and a VSS dummy metal line **804** are formed. For example, in an even-numbered wiring layer, a dummy metal line is connected to the VDD dummy metal pole **801,** and, in an odd-numbered wiring layer, a dummy metal line is connected to the VSS dummy metal pole **802.**

As described above, according to the semiconductor device of this embodiment, a dummy metal line is formed in one of wiring layers without shifting into another of the wiring layers, and in addition, when a dummy metal line formed in an even-numbered wiring layer have the opposite polarity to that formed in an odd-numbered wiring layer, a circuit can be easily modified like the eighth embodiment. Furthermore, when the polarity of a dummy metal line varies according to the wiring layer in which the dummy metal line is formed, this can prevent dummy metal lines from becoming shorted. With the configuration of the semiconductor device of this embodiment, a wiring capacitance can be formed between dummy metal lines.

### (Embodiment 10)

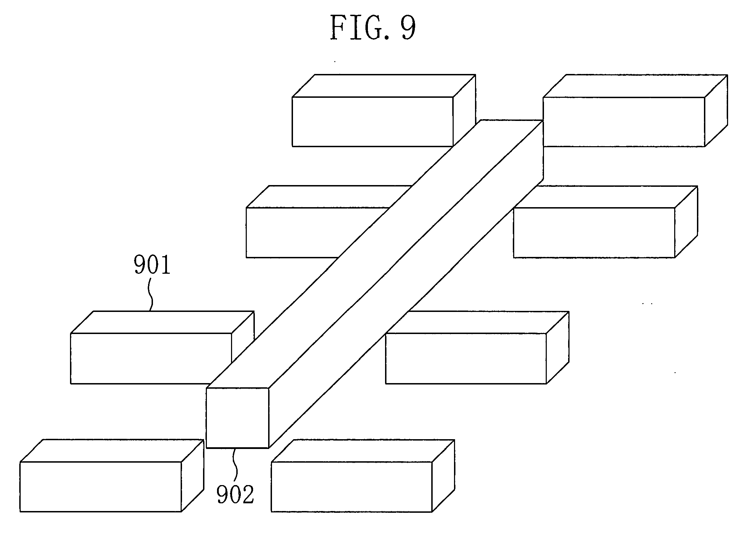

FIG. **9** is a perspective view showing a semiconductor device according to a tenth embodiment of the present invention. As shown in FIG. **9,** the semiconductor device of this embodiment includes floating-node dummy metal lines **901** formed in a first wiring layer and a signal line **902** formed in a second wiring layer located on the first wiring layer. When viewed in a plane, the floating-node dummy metal lines **901** do not overlap with the signal line **902.**

When the semiconductor device of this embodiment is fabricated, floating-node dummy metal lines **901** are first formed in a first wiring layer. Next, parts of the floating-node dummy metal lines **901** that will cross a signal line **902** when viewed in a plane are removed. When the remaining parts of the floating-node dummy metal lines **901** do not satisfy the minimum line width and area corresponding to the design rule obtained based on the process conditions, all the remaining parts of the floating-node dummy metal lines **901** are removed. Next, a signal line **902** is formed in a second wiring layer, and then floating-node dummy metal lines are formed also in a third wiring layer located on the second wiring layer. Parts of the floating-node dummy metal lines crossing the signal line **902** when viewed in a plane are removed.

The removal of the parts of the floating-node dummy metal lines **901** overlapping with the signal line **902** may prevent a predetermined pattern area ratio from being achieved. In this case, the number of dummy patterns to be formed is increased with the aim of satisfying the design rule obtained based on the associated process conditions. Alternatively, when the width of each of the remaining parts of the floating-node dummy metal lines **901** after the removal is increased, this compensates for falling short of the pattern area ratio.

With the above structure, since dummy metal lines do not cross a signal line above or below the signal line, this can reduce the wiring capacitance even with the reduced thicknesses of interlayer films in microfabrication and reduce the signal transmission delay in the signal line. Furthermore, the area ratio of a dummy metal pattern can be adjusted.

### (Embodiment 11)

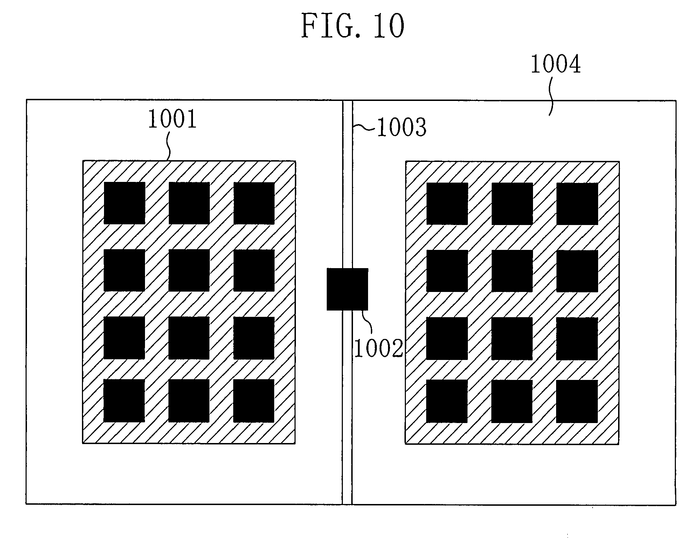

FIG. **10** is a diagram showing a semiconductor device according to an eleventh embodiment of the present invention. As shown in FIG. **10,** the semiconductor device of this embodiment includes a signal line **1003** on which an isolated contact hole **1002** is formed and dummy metal lines **1001** on which contact holes are formed in the wiring layer in which the isolated contact hole **1002** is formed (hereinafter, referred to as "with-contact-holes dummy metal lines **1001").** The with-contact-holes dummy metal lines **1001** are formed in a region **1004** of the wiring layer in which dummy metal lines can be formed (hereinafter, referred to as "dummy-metal-line formable region **1004").**

In some cases, a signal line **1003** is routed in coarse part of the dummy metal line formable region **1004,** and an isolated contact hole **1002** is formed so as to be connected to the signal line **1003.** When an isolated contact hole **1002** is formed, part of the dummy metal line formable region **1004** of the wiring layer in which the isolated contact hole **1002** is formed, which is located around the isolated contact hole **1002,** is unoccupied. Dummy metal lines **1001** are formed in the dummy metal line formable region **1004** to have contact holes in the wiring layer in which the isolated contact hole **1002** is formed. The with-contact-holes dummy metal lines **1001** may be connected to a power voltage supply unit or the ground but need not be connected thereto.

The above-described structure can suppress defective formation of contact holes that may be caused when an isolated contact hole has been formed. The reason for this is as follows.

It should be considered that the etching rate varies according to the area ratio between contacts and an oxide film both in a sampling area determined by the process conditions. In general, a process for forming patterns is developed by setting the etching rate in the existence of some contacts as the optimum etching rate. Therefore, such failures that the above-described ratio deviates from the optimized value in the region in which an isolated contact is formed become likely to be caused. To cope with this, the number of contact holes is increased by forming with-contact-holes dummy metal lines in the vicinity of an isolated contact hole. This can suppress contact failure.

The with-contact-holes dummy metal lines in the semiconductor device of this embodiment prevent the production yield from being reduced due to the absence of a contact hole on a signal line and are effective for the achievement of a predetermined area ratio of dummy metal lines.

The above-described semiconductor device of the present invention is useful for the reinforcement of power supply lines of an LSI and the enhancement of the production yield and useful in various devices using LSIs.

## Claims

1. A semiconductor device comprising:
a power voltage supply unit;
a plurality of power supply lines connected to the power voltage supply unit or ground, formed in a plurality of wiring layers and arranged in a grid-like form; and
a first dummy metal line formed in at least one of the plurality of wiring layers and connected at its two or more points to the power voltage supply unit or ground.

2. The semiconductor device of Claim 1 further comprising a second dummy metal line formed in at least one of the plurality of wiring layers and connected at its two or more points to one of the power sources having the opposite polarity to the power source to which the first dummy metal line is connected.

3. The semiconductor device of Claim 2, wherein
the first and second dummy metal lines are formed in different wiring layers.

4. The semiconductor device of Claim 1 further comprising an electrically isolated floating-node dummy metal line formed in one of the wiring layers other than another of the wiring layers in which the first dummy metal line and the power supply lines are formed.

5. The semiconductor device of Claim 4 further comprising a third dummy metal line formed in at least one of the plurality of wiring layers and connected at its two or more points to one of the power sources having the opposite polarity to the power source to which the first dummy metal line is connected,
wherein one of the wiring layers in which the first dummy metal line is formed and another of the wiring layers in which the third dummy metal line is formed are alternately stacked.

6. A semiconductor device comprising:
a plurality of wiring layers;
a power voltage supply unit; and
a plurality of power supply lines connected to the power voltage supply unit or ground and arranged in a grid-like form,
wherein, when some of the plurality of power supply lines connected to the power voltage supply unit are first power supply lines and the other ones of the plurality of power supply lines connected to the ground are second power supply lines, a plurality of pairs of the first and second power supply lines are formed in one of the wiring layers, two of the first power supply lines are adjacent to each other, and two of the second power supply lines are adjacent to each other,
a first dummy metal line is formed between adjacent two of the first power supply lines so as to be connected to the power voltage supply unit, and
a second dummy metal line is formed between adjacent two of the second power supply lines so as to be connected to the ground.

7. A semiconductor device comprising:
a plurality of wiring layers;
a power voltage supply unit;
an active element formed in a middle region of the semiconductor device;
an I/O cell for receiving a signal from the outside and transmitting a signal from the active element to the outside;
a plurality of power supply lines connected to the power voltage supply unit or ground, arranged in a grid-like form and formed in an outer region of the semiconductor device located around the middle region;
a dummy metal line formed in the outer region and connected at its two or more points to the power voltage supply unit or ground; and
an electrically isolated floating-node dummy metal line formed in a region other than the outer region.

8. The semiconductor device of Claim 7, wherein
another dummy metal line formed in the outer region and connected at its two or more points to the power voltage supply unit or ground is formed in at least one of the wiring layers other than the other ones of the wiring layers in which the power supply lines are formed.

9. A semiconductor device comprising:
a plurality of wiring layers;
a power voltage supply unit;
one or more dummy metal poles each passing through the plurality of wiring layers and connected to the power voltage supply unit or ground; and
a plurality of dummy metal lines each formed in one of the wiring layers without shifting into another of the wiring layers and connected to any one of the dummy metal poles.

10. The semiconductor device of Claim 9, wherein
the dummy metal poles comprise at least one first dummy metal pole connected to the power voltage supply unit and at least one second dummy metal pole connected to the ground, and
some of the wiring layers in which some of the dummy metal lines connected to the first dummy metal pole are formed and the other ones of the wiring layers in which the other ones of the dummy metal lines connected to the second dummy metal pole are formed are alternately stacked.

11. A semiconductor device comprising:
a plurality of wiring layers;
a signal line; and
an electrically isolated floating-node dummy metal line formed above or below one of the wiring layers in which the signal line is formed,
wherein the floating-node dummy metal line and the signal line are formed without overlapping with each other when viewed in a plane.

12. The semiconductor device of Claim 11, wherein
part of the floating-node dummy metal line crossing the signal line when viewed in a plane is removed.

13. A semiconductor device comprising a signal line and a dummy metal line formed in a wiring layer in which the signal line is formed,
wherein an isolated contact hole is formed to reach the signal line and a contact hole is formed in one of the wiring layers in which the isolated contact hole is formed to reach the dummy metal line.

14. A method for designing a semiconductor device using a computer including an input section, a voltage drop analysis section, a power supply path search section, dummy metal line layout data generation section, and an output section, said method comprising the steps of:
(a) entering before-dummy-metal-line-formation layout data of the semiconductor device into the input section;
(b) using the voltage drop analysis section to analyze the before-dummy-metal-line-formation layout data and identify part of the semiconductor device to which power is insufficiently supplied;
(c) using the power supply path search section to search for a power supply path for reinforcing, in the part of the semiconductor device to which power is insufficiently supplied, power supply lines by using a dummy metal line and the polarity of the dummy metal line; and
(d) using the dummy metal line layout data generation section to generate layout data of the dummy metal line based on the path and polarity determined in the step (c).
